# EUROPEAN PATENT SPECIFICATION

(11) **EP 3 290 460 B1**
(45) Date of publication and mention of the grant of the patent: **04.03.2020**
(21) Application number: 17187236.9
(22) Date of filing: 22.08.2017
(51) Int. Cl.: C08G 73/06, C08K 9/06, H01L 23/29

(54) **HEAT-CURABLE RESIN COMPOSITION FOR SEMICONDUCTOR ENCAPSULATION**
WÄRMEHÄRTBARE HARZZUSAMMENSETZUNG FÜR HALBLEITEREINKAPSELUNG
COMPOSITION DE RÉSINE THERMODURCISSABLE POUR L'ENCAPSULATION DE SEMI-CONDUCTEURS

(30) Priority: 01.09.2016 JP 2016170688
(43) Date of publication of application: 07.03.2018
(73) Proprietor: Shin-Etsu Chemical Co., Ltd., Chiyoda-ku, Tokyo 100-0004 (JP)
(72) Inventor: SUMITA, Kazuaki, Annaka-shi, Gunma 379-0224 (JP); NAKAMURA, Tomoaki, Annaka-shi, Gunma 379-0224 (JP); KUSHIHARA, Naoyuki, Annaka-shi, Gunma 379-0224 (JP)
(74) Representative: Zacco GmbH

(56) References cited:
- JP-A- 2015 044 939
- JP-A- 2015 048 472
- US-A1- 2016 186 024

## Description

### [Technical field]

The present invention relates to a heat-curable resin composition for semiconductor encapsulation; and a method for producing a resin-encapsulated semiconductor device, using a cured product of the aforementioned composition.

### [Background art]

In recent years, mobile information-communication terminals such as smart phones and tablets are equipped with thin, small-sized multifunctional semiconductor devices that are capable of performing high-speed processing, such that a large volume of information can be processed at a high speed. These semiconductor devices are produced as follows (Patent document 1). That is, TSV (Through Silicon Via) technology is employed to connect semiconductor elements through multi-layer bonding, followed by performing flip chip bonding on the multilayered semiconductor elements on an 8-inch or 12-inch silicon interposer, and then using a heat-curable resin to encapsulate each interposer with a plurality of the multilayered semiconductor elements mounted thereon. The encapsulated package is then divided into individual pieces after abrading the unwanted cured resin on the semiconductor elements.

As for the production of a semiconductor device, encapsulation molding can be performed without any major problems even under the current situation, as long as a substrate such as a small-diameter wafer is used. However, an epoxy resin or the like tends to exhibit a significant contraction stress after encapsulation, when performing molding on a wafer of a size of not smaller than 8 inches, or of a size of 20 inches in recent years; or on a panel of a size of greater than 20 inches. For this reason, there has been a problem that a semiconductor element(s) will be stripped off from a substrate made of a metal or the like, which makes it difficult to conduct mass production. In order to solve the aforementioned problem associated with the increase in diameter of a wafer, a glass substrate and a metal substrate, it has been required that a resin be filled with a filler by an amount of not smaller than 90% by mass, or that a contraction stress at the time of curing be reduced through a reduction in elasticity of a resin (Patent document 2).

However, in the case where a silicon interposer is to be entirely encapsulated by a heat-curable resin, a significant warpage will occur due to a difference in thermal expansion coefficient between silicon and the heat-curable resin. A significant warpage makes it unsuitable to perform an abrading step and a dicing step later. That is, it has been a major technical issue to prevent warpage.

Conventionally, there has been used an encapsulation material prepared by filling a composition containing an epoxy resin and a curing agent such as an acid anhydride and a phenolic resin with a filler by an amount of not smaller than 85% by mass, and then adding a rubber and/or a thermoplastic resin thereto for stress relaxation. This type of composition bears a problem that a warpage will occur due to a thermal history associated with a step(s) in 3D packaging, and that such warpage will then lead to damages of a semiconductor element(s) or even the breakage of a wafer itself. Meanwhile, since the resin component in a low-elastic resin material as typified by a conventional silicone compound is soft, there have been problems that resin clogging will occur at the time of performing abrading, and that resin cracks will occur during a reliability test (Patent document 3).

### [Prior art document]

### [Patent document]

[Patent document 1] JP-A-2014-229771
[Patent document 2] JP-A-2012-209453
[Patent document 3] JP-A-Hei11-289034
[Patent document 4] JP-A-2014-263000 (US equivalent: US 2016/186024 A1)

### [Summary of the invention]

### [Problem to be solved by the invention]

It is an object of the present invention to provide a highly versatile heat-curable resin composition for semiconductor encapsulation that exhibits a favorable water resistance and abradability when used to encapsulate a semiconductor device; and a superior fluidity and a small degree of warpage even when used to perform encapsulation on a large-sized wafer.

### [Means to solve the problem]

The inventors of the present invention diligently conducted a series of studies to solve the abovementioned problems, and completed the invention as follows. That is, the inventors found that the above objective could be achieved by a heat-curable resin composition obtained by combining a particular cyanate ester compound, a particular phenol curing agent, a particular inorganic filler and a particular ester compound.

Specifically, the present invention is to provide the following heat-curable resin composition for semiconductor encapsulation; and a method for producing a resin-encapsulated semiconductor device, using a cured product of such composition.
[1] A heat-curable resin composition for semiconductor encapsulation, comprising:
   (A) a cyanate ester compound having not less than two cyanato groups in one molecule, the cyanate ester compound containing a cyanate ester compound (A-1) represented by the following formula (1) the cyanate ester compound (A-1) being contained in the whole cyanate ester compound as the component (A) by an amount of not smaller than 90% by mass, and exhibiting a viscosity of not higher than 50 Pa·s at 23°C when measured by a B-type rotary viscometer in accordance with a method described in JIS K7117-1:1999 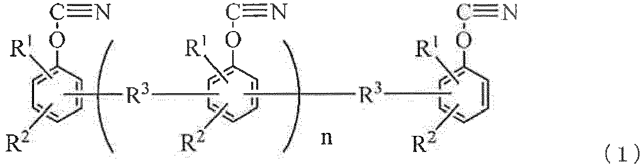 wherein n represents an integer of 0 or 1; each of R¹ and R² represents a hydrogen atom or an alkyl group having 1 to 4 carbon atoms; and R³ represents a divalent linking group selected from the groups expressed by the following formulae (2) to (5)

      -CH₂- (2)

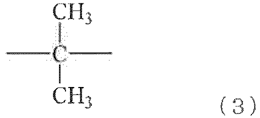

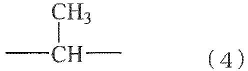

      -O- (5) ;
   (B) a phenol curing agent containing a resorcinol-type phenolic resin represented by the following formula (6), the component (B) being contained at a ratio at which the cyanato groups (CN groups) in the component (A) is in an amount of 0.5 to 100 equivalents per 1 equivalent of the hydroxyl groups (OH groups) in the component (B), 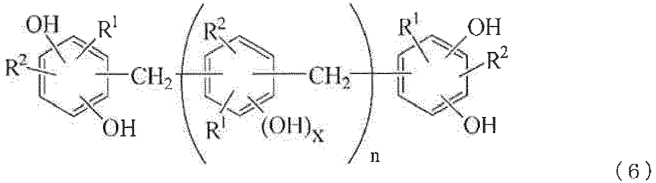 wherein n represents an integer of 0 to 10; each of R¹ and R² independently represents a hydrogen atom or a monovalent group selected from the group consisting of an alkyl group having 1 to 10 carbon atoms, an allyl group and a vinyl group; and x represents 1 or 2;
   (C) a curing accelerator in an amount of 0.01 to 5 parts by mass per 100 parts by mass of the component (A);
   (D) an inorganic filler comprising particles having either spherical spherical or deformed sphere shapes, exhibiting on average an aspect ratio of 1 to 4, has an average particle diameter of 1 to 20 µm when measured by a laser diffraction method, the component (D) being in an amount of 1,200 to 2,200 parts by mass per 100 parts by mass of a sum total of the components (A) and (B), and has been surface-treated with a silane coupling agent represented by the following formula (7), the silane coupling agent being contained in an amount of 0.2 to 0.5 parts by mass per 100 parts by mass of the inorganic filler,

      R¹ₐ(OR²)₍₃₋ₐ₎Si-C₃H₆-R³ (7)

      wherein a represents an integer of 0 to 3; R¹ represents a methyl group or an ethyl group; R² represents an alkyl group having 1 to 3 carbon atoms; and R³ represents a group selected from the group consisting of the nitrogen-containing functional groups represented by the following formulae (8) to (11)
      -NH₂ (8)

      -NHC₆H₅ (9)

      -NHC₂H₄NH₂ (10)

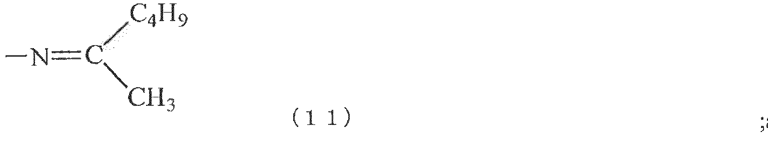

      and
   (E) an ester compound that is in an amount of 1 to 10 parts by mass per 100 parts by mass of the sum total of the components (A) and (B), and is represented by the following formula (12)

      R⁴-CH₂CH₂-NH-CH₂CH₂-R⁵ (12)

      wherein each of R⁴ and R⁵ represents a saturated ester residue having 2 to 30 carbon atoms.
[2] (not claimed) The heat-curable resin composition for semiconductor encapsulation according to [1], wherein cyanate ester compound content in the component (A) except for the cyanate ester compound (A-1) represented by the formula (1) is an amount of smaller than 10% by mass with respect to the whole amount of the component (A).
[3] (not claimed) The heat-curable resin composition for semiconductor encapsulation according to [1] or [2], wherein the resorcinol-type phenolic resin represented by the formula (6) is contained in the component (B) by an amount of 10 to 100% by mass with respect to the whole amount of the component (B).
[4] The heat-curable resin composition for semiconductor encapsulation according to any one of [1] to [3], wherein cyanato groups in the cyanate ester compound as the component (A) are in an amount of 0.5 to 100 equivalents per 1 equivalent of hydroxyl groups in the phenol curing agent as the component (B).
[5] The heat-curable resin composition for semiconductor encapsulation according to any one of [1] to [4], exhibiting a linear expansion coefficient of 3.0 to 5.0 ppm/°C as a result of measuring a 5×5×15 mm specimen at a rate of temperature increase of 5°C / min and under a load of 19.6 mN, in accordance with a method described in JIS K 7197:2012.
[6] A method for producing a resin-encapsulated semiconductor device, comprising:
   a step of using a cured product of the heat-curable resin composition for semiconductor encapsulation as set forth in any one of [1] to [5] to collectively encapsulate an entire silicon wafer or substrate with at least one semiconductor element mounted thereon, wherein the heat-curable resin composition for semiconductor encapsulation is applied either in a pressurized manner, or in a depressurized manner under a vacuum atmosphere, before being heated and cured to encapsulate the semiconductor element.

### [Effects of the invention]

According to the present invention, there can be obtained a semiconductor device superior in heat resistance and moisture resistance, and barely exhibiting warpage when cooled after being heated and cured, even in the cases of encapsulating a semiconductor element array with at least one semiconductor element mounted on an inorganic substrate, a metal substrate or an organic substrate through an adhesive agent (die bonding material); or encapsulating a large wafer with a semiconductor(s) formed thereon.

### [Brief description of the drawings]

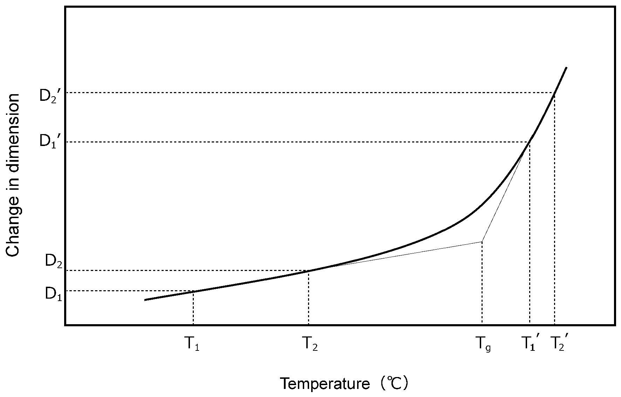

FIG.1 is a diagram showing a method for determining a glass-transition temperature.

### [Mode for carrying out the invention]

The present invention is described in detail hereunder. However, the invention is not limited to the following examples.

### (A) Cyanate ester compound

A component (A) is a main component of the composition of the invention, and is a cyanate ester compound having at least two cyanato groups. The component (A) contains the compound represented by the above formula (1).

It is to be noted that the compound i.e. (A-1) represented by the above formula (1) exhibit a viscosity of not higher than 50 Pa·s at 23°C, particularly preferably not higher than 20 Pa·s at 23°C, when measured by a B-type viscometer in accordance with a method described in JIS K7117-1:1999. When this viscosity is greater than 50 Pa·s, the composition cannot be filled with a sufficient amount of an inorganic filler such that the expansion coefficient of the composition will become large. In such case, a significant warpage may be observed as a result of performing molding on a wafer of a size of not smaller than 12 inches, thus making it impossible to obtain a sheet-shaped product.

In the present invention, the cyanate ester compound i.e. (A-1) represented by the formula (1) may be mixed and used in combination with another cyanate ester compound having at least two cyanato groups in one molecule. As such cyanate ester compound other than that represented by the formula (1) that has at least two cyanato groups, there may be used a known cyanato ester compound. Examples of such cyanato ester compound include bis (4-cyanatophenyl) methane; bis (3-methyl-4-cyanatophenyl) methane; bis (3,5-dimethyl-4-cyanatophenyl) methane; 1,1-bis (4-cyanatophenyl) ethane; 2,2-bis (4-cyanatophenyl) propane; 2,2-bis (4-cyanatophenyl)-1,1,1,3,3,3-hexafluoropropane; 1,3-dicyanatobenzene; 1,4-dicyanatobenzene; 2-tert-butyl-1,4-dicyanatobenzene; 2,4-dimethyl-1,3-dicyanatobenzene; 2,5-di-tert-butyl-1,4-dicyanatobenzene; tetramethyl-1,4-dicyanatobenzene; 1,3,5-tricyanatobenzene; 2,2'-dicyanatobiphenyl; 4,4'-dicyanatobiphenyl; 3,3',5,5'-tetramethyl-4,4'-dicyanatobiphenyl; 1,3-dicyanatonaphthalene; 1,4-dicyanatonaphthalene; 1,5-dicyanatonaphthalene; 1,6-dicyanatonaphthalene; 1,8-dicyanatonaphthalene; 2,6-dicyanatonaphthalene; 2,7-dicyanatonaphthalene; 1,3,6-tricyanatonaphthalene; 1,1,1-tris(4-cyanatophenyl) ethane; bis (4-cyanatophenyl) ether; 4,4'-(1,3-phenylenediisopropylidene) diphenylcyanate; bis (4-cyanatophenyl) thioether; bis (4-cyanatophenyl) sulfone; tris (4-cyanato-phenyl) phosphine; a phenol novolac-type cyanate; a cresol novolac-type cyanate; and a dicyclopentadiene novolac-type cyanate.

The cyanate ester compound i.e. (A-1) represented by the formula (1) is contained in the whole cyanate ester compound as the component (A) having at least two cyanato groups, by an amount of not smaller than 90% by mass. When the cyanate ester compound represented by the formula (1) is contained in an amount of smaller than 90% by mass, the composition cannot be filled with a sufficient amount of an inorganic filler such that there may not be obtained a sheet-shaped product. In other words, it is preferred that the cyanate ester compound other than the cyanate ester compound represented by the formula (1) be contained in the whole component (A) by an amount of smaller than 10% by mass.

It is preferred that the cyanate ester compound as the component (A) be contained in the whole resin composition by an amount of 3 to 10% by mass, more preferably 3 to 7% by mass, most preferably 3 to 5% by mass.

### (B) Phenol curing agent

A component (B) is a phenol curing agent containing a resorcinol-type phenolic resin represented by the following formula (6).

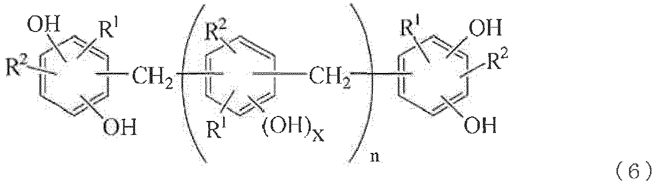

In the formula (6), n represents an integer of 0 to 10; each of R¹ and R² independently represents a hydrogen atom or a monovalent group selected from the group consisting of an alkyl group having 1 to 10 carbon atoms, an allyl group and a vinyl group.

It is to be noted that "n" in the above formula (6) be 0 to 10 in terms of melt fluidity. When "n" is greater than 10, the component (B) will not melt at a temperature of 100°C or lower, thus resulting in an impaired fluidity of the resin composition. Each of R¹ and R² represents a hydrogen atom or a monovalent group selected from the group consisting of an alkyl group having 1 to 10 carbon atoms, an allyl group and a vinyl group; and it is preferred that each of R¹ and R² be a hydrogen atom or a monovalent group selected from the group consisting of an alkyl group having 1 to 4 carbon atoms, an allyl group and a vinyl group. R¹s may be functional groups that are identical to or different from one another. Further, R²s may also be functional groups that are identical to or different from one another. Here, when each of R¹ and R² is a group having more than 10 carbon atoms, the resin composition will not exhibit a sufficient heat resistance.

Further, as the component (B), two or more kinds of the resorcinol-type phenolic resins (formula (6)) with different values of "n" may be mixed together and used in combination; or there may be used a resorcinol-type phenolic resin (formula (6)) exhibiting a variation in the value of "n."

The phenol curing agent (B) and the cyanate ester compound (A) is added at a ratio at which the cyanato groups in the component (A) will be in an amount of 0.5 to 100 equivalents, preferably 1 to 50 equivalents, or more preferably 5 to 35 equivalents, per 1 equivalent of the hydroxyl groups (OH groups) in the phenol curing agent (B). When the cyanato groups are in an amount of greater than 100 equivalents per 1 equivalent of the hydroxyl groups (OH groups), the resin composition will be cured insufficiently; and when the cyanato groups are in an amount of smaller than 0.5 equivalents per 1 equivalent of the hydroxyl groups (OH groups), the heat resistance of the cyanate ester compound (A) itself may be impaired.

Further, with regard to the phenol curing agent (B), it is preferred that the resorcinol-type phenolic resin represented by the formula (6) be contained in the whole component (B) by an amount of 10 to 100% by mass. When the component (B) contains the resorcinol-type phenolic resin represented by the formula (6), a resin viscosity at the time of melting the component (B) can be reduced, and a curing reaction of the cyanate ester compound (A) can be promoted. Moreover, since the resorcinol-type phenolic resin itself has a high heat resistance, there can be obtained a cured product having a superior heat resistance. Here, as a phenol curing agent other than the resorcinol-type phenolic resin represented by the formula (6), there may be listed a phenol curing agent represented by the following formula (13).

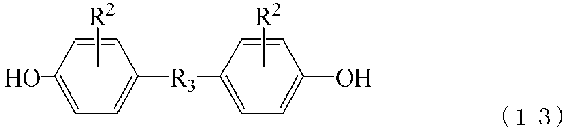

In the formula (13), R² represents a monovalent hydrocarbon group having a double bond(s) and not more than 10 carbon atoms; R³ represents any one of the divalent hydrocarbon groups represented by the following formulae.

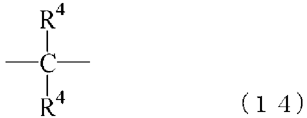

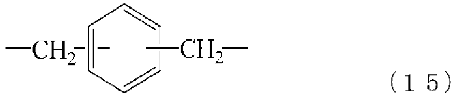

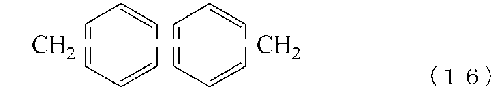

In the formula (14), R⁴ represents a hydrogen atom or a monovalent hydrocarbon group having not more than 10 carbon atoms.

### (C) Curing accelerator

Examples of a component (C) include 1,8-diazabicyclo [5.4.0] undecene-7 (DBU); 1,5-diazabicyclo [4.3.0] nonene-5 (DBN); N-alkyl substituents of these DBU and DBN; N-aryl substituents of these DBU and DBN; salts of these nitrogen-containing heterocyclic compounds; and amine-based curing accelerators. It is preferred that the curing accelerator as the component (C) be added in an amount of not larger than 5 parts by mass, more preferably 0.01 to 5 parts by mass, per 100 parts by mass of the component (A).

Specific examples of salts of DBU include a phenolate, an octylate, a p-toluenesulfonate, a formate, an orthophthalate, a trimellitic anhydride salt, a phenol novolac resin salt and a tetraphenylborate.

Specific examples of salts of DBN include a phenolate, an octylate, a p-toluenesulfonate, a formate, an orthophthalate, a trimellitic anhydride salt, a phenol novolac resin salt and a tetraphenylborate.

Examples of the amine-based curing accelerator include aromatic amine-based curing accelerators such as 3,3'-diethyl-4,4'-diaminodiphenylmethane, 3,3',5,5'-tetramethyl-4,4'-diaminodiphenylmethane, 3,3',5,5'-tetraethyl-4,4'-diaminodiphenylmethane, 2,4-diaminotoluene, 1,4-phenylenediamine, 1,3-phenylenediamine, diethyltoluenediamine, 3,4'-diaminodiphenyl ether, 3,3'-diaminodiphenylmethane, 3,4'-diaminodiphenylmethane, 4,4'-diaminodiphenylmethane, 3,3' -diaminobenzidine, orthotolidine, 3,3' -dimethyl-4,4' -diaminodiphenylmethane, 2,6-diaminotoluene and 1,8-diaminonaphthalene; chain aliphatic polyamines such as N,N'-bis (3-aminopropyl) ethylenediamine, 3,3'-diaminodipropylamine, 1,8-diaminooctane, 1,10-diaminodecane, diethylenetriamine, triethylenetetramine and tetraethylenepentamine; cyclic aliphatic polyamines such as 1,4-bis (3-aminopropyl) piperazine, N-(2-aminoethyl) piperazine, N-(2-aminoethyl) morpholine and isophoronediamine; polyamidoamine; an imidazole-based curing accelerator; and a guanidine-based curing accelerator. The abovementioned polyamidoamine is produced by condensation of a dimer acid and a polyamine, and examples of such polyamidoamine include adipic dihydrazide and 7,11-octadecadiene-1,18-dicarbohydrazide. Examples of the abovementioned imidazole-based curing accelerator include 2-methylimidazole, 2-ethyl-4-methylimidazole and 1,3-bis (hydrazinocarbonoethyl)-5-isopropylhydantoin. Examples of the abovementioned guanidine-based curing accelerator include aliphatic amines such as 1,3-diphenylguanidine and 1,3-di-o-tolylguanidine. It is particularly preferred that an imidazole-based curing accelerator be used.

### (D) Inorganic filler

As an inorganic filler added to the resin composition of the present invention, there may be used those normally added to an epoxy resin composition. Specific examples of such inorganic filler include silicas such as a molten silica and a crystalline silica; alumina; silicon nitride; aluminum nitride; boron nitride; titanium oxide; and glass fibers.

It is to be noted that such inorganic filler be spherical; and have an average particle diameter of 1 to 20 µm, particularly 3 to 15 µm when measured by a laser diffraction method. Moreover, such inorganic filler is surface-treated with a silane coupling agent represented by the following formula (7).

In this specification, the notion "spherical" does not only refer to a case where the shapes of the particles are true spheres, but also to a case where the shapes of the particles are deformed spheres exhibiting on average an aspect ratio (longest-axis length / shortest-axis length) of 1 to 4 in general, preferably 1 to 2, more preferably 1 to 1.6, or even more preferably 1 to 1.4. The shapes of the particles can be confirmed by observing these particles through an optical microscope and/or an electronic microscope.

R¹ₐ(OR²)₍₃₋ₐ₎Si-C₃H₆-R³ (7)

In the formula (7), R¹ represents a methyl group or an ethyl group; R² represents an alkyl group having 1 to 3 carbon atoms; R³ represents a group selected from the group consisting of the nitrogen-containing functional groups represented by the following formulae (8) to (11); and a represents an integer of 0 to 3.

-NH₂ (8)

-NHC₆H₅ (9)

-NHC₂H₄NH₂ (10)

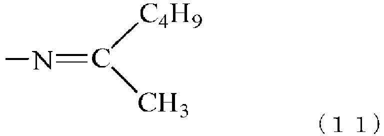

The aforementioned surface treatment improves the affinity between the inorganic filler (D) and the cyanate ester compound (A) so as to strengthen the bond between the component (A) and the component (D), and then allow the fluidity of the resin composition to be improved significantly. A known method may be employed as such surface treatment method using the silane coupling agent. In fact, there are no particular restrictions on this surface treatment method.

One example of the silane coupling agent used as a surface treatment agent for the component (D) may be N-phenyl-3-aminopropyltrimethoxysilane.

The silane coupling agent represented by the formula (7) is added in an amount of 0.2 to 0.5 parts by mass per 100 parts by mass of the inorganic filler. When the silane coupling agent is added in a small amount, the cyanate ester compound and the inorganic filler may not be bonded together in a sufficient manner, or there may not be achieved a sufficient fluidity of the resin composition. Meanwhile, a larger expansion coefficient may be resulted if the silane coupling agent is added in a large amount.

It is to be noted that the component (D) be added in an amount of 1,200 to 2,200 parts by mass, more preferably 1,400 to 2,000 parts by mass, per 100 parts by mass of a sum total of the components (A) and (B). When the component (D) is added in an amount smaller than such lower limit value, a molded wafer will exhibit a significant warpage in a way such that there cannot be achieved a sufficient strength. Further, when the component (D) is added in an amount greater than such upper limit, the resin composition will exhibit a significantly poor fluidity, and a semiconductor element(s) arranged on a submount cannot be encapsulated completely.

### (E) Ester compound

A component (E) is an ester compound represented by the following formula (12).

R⁴-CH₂CH₂-NH-CH₂CH₂-R⁵ (12)

Each of R⁴ and R⁵ represents a saturated ester residue having 2 to 30 carbon atoms.

In the formula (12), it is preferred that each of R⁴ and R⁵ be a saturated ester residue having 15 to 30 carbon atoms, preferably 20 to 30 carbon atoms. Specifically, it is preferred that each of R⁴ and R⁵ be a montanic acid ester.

It is to be noted that the component (E) be added in an amount of 1 to 10 parts by mass, more preferably 1 to 6 parts by mass, per 100 parts by mass of the sum total of the components (A) and (B). When the component (E) is added in an amount of smaller than 1 part by mass, the wafer may exhibit a significant warpage. When the amount of the component (E) added is greater than 10 parts by mass, a significantly poor formability will be observed, and the adhesion to a silicon wafer and a silicon chip may be impaired in a significant manner as well. As a typical compound as the component (E), NC133 (by Itoh Oil Chemicals Co., Ltd.) is preferred.

### (F) Other additives

The heat-resistant resin composition of the invention can be obtained by combining the above components (A) to (E) in given amounts. However, other additives may also be added to the composition of the invention if necessary, without impairing the objectives and effects of the present invention. Examples of such additives include an inorganic filler, a flame retardant, an ion trapping agent, an antioxidant, an adhesion imparting agent, a low stress agent and a coloring agent.

The flame retardant is added to impart a flame retardant property. Here, all the known flame retardants may be used in the present invention. Examples of such flame retardant include a phosphazene compound, a silicone compound, a zinc molybdate-supported talc, a zinc molybdate-supported zinc oxide, aluminum hydroxide, magnesium hydroxide and molybdenum oxide.

The ion trapping agent is added to trap the ion impurities contained in the resin composition, and avoid a thermal degradation and a moisture absorption degradation. Here, all the known ion trapping agents may be used in the present invention. Examples of such ion trapping agents include hydrotalcites, a bismuth hydroxide compound and rare-earth oxides.

The adhesion imparting agent is added to impart an adhesion with respect to a chip and a substrate that are to be encapsulated. Here, all the known adhesion imparting agents may be used in the present invention. Examples of such adhesion imparting agents include a silane compound and a polysiloxane compound that have in their molecules a hydrolyzable silyl group(s); and an adhesive functional group(s) such as a vinyl group, an amino group, an epoxy group, a (metha) acrylic group and a mercapto group.

Examples of such silane compound include vinyltrimethoxysilane, vinyltriethoxysilane, 2-(3,4-epoxycyclohexyl) ethyltrimethoxysilane, γ-glycidoxypropyltrimethoxysilane, γ-glycidoxypropyltriethoxysilane, γ-glycidoxypropylmethyldiethoxysilane, γ-methacryloxypropylmethyldiethoxysilane, γ-acryloxypropyltrimethoxysilane, N-2-(aminoethyl)-3-aminopropyltrimethoxysilane, N-2-(aminoethyl)-3-aminopropylmethyldiethoxysilane, N-phenyl-3-aminopropyltrimethoxysilane, γ-aminopropyltnmethoxysilane and γ-mercaptopropyltrimethoxysilane. Further, the above polysiloxane compound may be circular, chainlike or netlike.

Although the amount of the component (F) added varies depending on the intended purpose of the resin composition, it is normally added in an amount of not larger than 20% by mass with respect to the whole composition.

### Method for preparing heat-curable resin composition

The heat-curable resin composition of the invention can, for example, be prepared through the method shown below.

In the beginning, a mixture of the components (A) and (B) is obtained by simultaneously or separately mixing, stirring, and/or dispersing the cyanate ester compound (A) and the phenol curing agent (B) while performing a heating treatment if necessary. A mixture of the components (A) to (C) and (E) is then obtained by mixing, stirring, and/or dispersing the curing accelerator (C), the ester compound (E) and the mixture of the components (A) and (B). Further, a mixture of the components (A) to (E) is obtained by mixing, stirring, and/or dispersing the inorganic filler (D); and the mixture of the components (A) to (C) and (E). In addition, at least one of the flame retardant and ion trapping agent as an additive(s) may be added to mixed with the mixture of the components (A) and (B), the mixture of the components (A) to (C) and (E), and the mixture of the components (A) to (E), depending on the intended use.

There are no particular restrictions on a device(s) for performing, for example, mixing, stirring and dispersion. However, specific examples of such device(s) include a kneader equipped with a stirring and heating devices, a twin-roll mill, a triple-roll mill, a ball mill, a continuous extruder, a planetary mixer and a mass-colloider. These devices may also be appropriately used in combination.

The heat-curable resin composition of the present invention can be molded through the conventional compression molding or laminating molding. Particularly, it is preferred that compression molding be performed. In such case, it is preferred that the resin composition be molded at a molding temperature of 160 to 180°C for 300 to 600 sec, and that post-curing be then performed at 160 to 180°C for 1 to 6 hours.

The composition of the invention is capable of yielding a small level of warpage even when molded on a large-sized wafer such as an 8 inch, 12 inch or 20 inch wafer. Further, the cured product of the resin composition of the invention is superior in mechanical strength and insulation properties, and a semiconductor device encapsulated by such cured product is superior in long-term reliability. Moreover, the resin composition of the invention is also superior in productivity due to the fact that molding failures such as flow mark and filling failure will not occur when using the device(s) for conventional molding such as compression or laminating molding under the conventional conditions.

In this specification, a large-sized wafer refers to a substrate having a dimeter not smaller than 8 inches (i.e. 20 cm). Examples of such substrate include 8 inch, 12 inch and 20 inch silicon wafers.

A flow mark referred to in this specification is a white flow mark radially formed from the center of the molded product toward the outer side. The occurrence of such flow mark may lead to, for example, a poor appearance; a variation in the properties of the cured product due to an ununiformly dispersed silica; and an impaired reliability associated with such variation.

A filling failure referred to in this specification refers to a missing portion of resin that occurs on the outer circumferential region of a wafer. The occurrence of such filling failure may cause a sensor to erroneously recognize the unfilled portion as a notch when transporting the wafer in a later step(s). There, a position adjustment property may be impaired.

### Working example

Described below are working examples of the present invention. However, the invention is not limited to the following examples. Here, a viscosity referred to in this specification is a viscosity measured by a B-type rotary viscometer at 23°C, in accordance with a method described in JIS K7117-1:1999.

### Method for producing sheet-like heat-curable resin composition

A heat-curable resin composition was obtained by mixing all the following components as those contained in the heat-curable resin composition at the ratios shown in Table 1, and then kneading the same with a twin-roll mill. In Table 1, the unit for the numerical values representing the compounding ratios is "part by mass."

The mixture of the heat-curable resin composition obtained above was applied to the surface of a polyester film (protection layer) that had been subjected to a mold release treatment, followed by using a heated roll mill to form the mixture to a thickness of 100 µm. In this way, obtained were sheet-like cured products of working examples 1 to 5 and comparative examples 1 to 7. In comparative examples 4 to 7, a poor wettability was observed between the resin and the inorganic filler such that the composition of the invention failed to be formed into a sheet-like shape. The following tests and evaluations were then performed on the compositions (working examples 1 to 5; comparative examples 1 to 3) that had been able to be formed into a sheet-like shape(s).

### (A) Cyanate ester compound

(A1) 1,1-bis (4-cyanatophenyl) ethane represented by the following formula (17) (viscosity: 0.08 Pa·s) (product name: LECy by LONZA Group Ltd.) 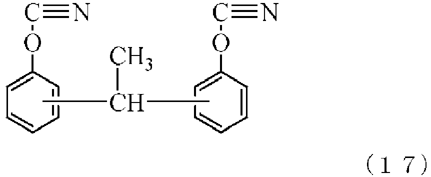
(A2) Phenol novolac-type cyanate ester represented by the following formula (18) (n=0 to 2) (viscosity: 250 Pa·s) (product name: PT30 by LONZA Group Ltd.)

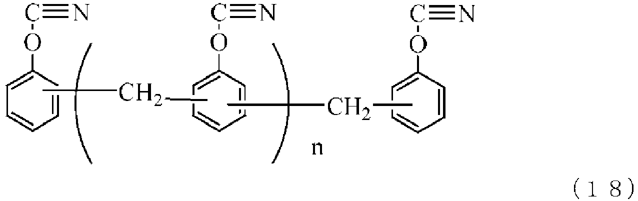

### (B) Phenol curing agent

(B1) Resorcinol-type phenolic resin represented by the following formula (19) (n=0 to 4; each of R¹ and R² represents an allyl group; weight-average molecular weight 450 to 600; equivalent 107) (product name: MEH-8400 by MEIWA PLASTIC INDUSTRIES, LTD)
(B2) Resorcinol-type phenolic resin represented by the following formula (19) (n=5 to 7; each of R¹ and R² represents an allyl group; weight-average molecular weight 800 to 1,100; equivalent 132) (by MEIWA PLASTIC INDUSTRIES, LTD)

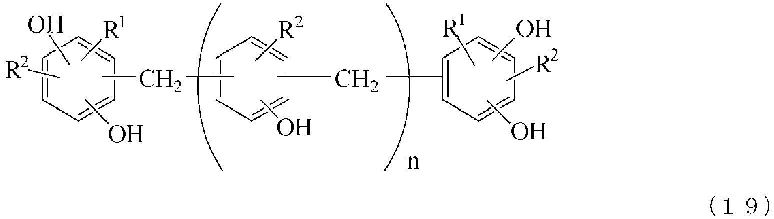

### (C) Curing accelerator

(C1) DBU-type tetraphenylborate salt (product name: U-CAT 5002 by by San-Apro Ltd.)

### (D) Inorganic filler

### (D1) Treated silica

A treated silica (D1) was prepared by performing dry surface treatment on 100 parts by mass of a base spherical molten silica (spherical molten silica with an average particle diameter of 12 µm (by TATSUMORI LTD.)) with 0.3 parts by mass of an N-phenyl-3-aminopropyltrimethoxysilane (product name: KBM573 by Shin-Etsu Chemical Co., Ltd.).

### (D2) Treated silica

A treated silica (D2) was prepared by performing dry surface treatment on 100 parts by mass of a base spherical molten silica (spherical molten silica with an average particle diameter of 12 µm (by TATSUMORI LTD.)) with 0.3 parts by mass of a γ-glycidoxypropyltrimethoxysilane (product name: KBM403 by Shin-Etsu Chemical Co., Ltd.).

### (D3) Treated silica

A treated silica (D3) was prepared by performing dry surface treatment on 100 parts by mass of a base spherical molten silica (spherical silica with an average particle diameter of 0.8 µm (by TATSUMORI LTD.)) with 0.3 parts by mass of the N-phenyl-3-aminopropyltrimethoxysilane (product name: KBM573 by Shin-Etsu Chemical Co., Ltd.).

### (D4) Non-treated silica

The spherical molten silica used in (D1) (by TATSUMORI LTD., average particle diameter of 12 µm) was used without performing surface treatment thereon.

### (E) Ester compound

(El) Montanic acid ester compound represented by the following formula (20)

C₂₇H₅₅-COO-CH₂CH₂-NH-CH₂CH₂-OOC-C₂₇H₅₅ (20)

### (F) Other additives

(F1) Adhesion imparting agent: γ-glycidoxypropyltrimethoxysilane (product name: KBM403 by Shin-Etsu Chemical Co., Ltd.).
(F2) Coloring agent: carbon black (product name: Mitsubishi carbon black 3230MJ by Mitsubishi Chemical Corporation)

### Test and evaluation method

### Glass-transition temperature and linear expansion coefficient

Each of the sheet-like cured products produced in the working and comparative examples in accordance with JIS K 7197 : 2012, was processed into a specimen of a size of 5 × 5 × 15 mm, followed by placing the same in a thermal dilatometer TMA 8140C (by Rigaku Corporation). A change in size of the specimen was then measured at a rate of temperature increase of 5°C/min from 25°C to 300°C, with a constant load of 19.6 mN being applied to the specimen. The correlation between such change in size and the temperatures was then plotted on a graph. The glass-transition temperatures in the working and comparative examples were later obtained based on such graph showing the correlation between the change in size and the temperatures, and through the following method for determining the glass-transition temperature(s).

### Method for determining glass-transition temperature

In FIG.1, T₁ and T₂ represent two arbitrary temperatures that are not higher than the temperature at the inflection point and by which a tangent line to the size change-temperature curve can be drawn; whereas T₁' and T₂' represent two arbitrary temperatures that are not lower than the temperature at the inflection point and by which a similar tangent line can be drawn. D₁ and D₂ individually represent a change in size at T₁ and a change in size at T₂; whereas D₁' and D₂' individually represent a change in size at T₁' and a change in size at T₂'. The glass-transition temperature (Tg) is then defined as the temperature at the point of intersection between a straight line connecting points (T₁, D₁) and (T₂, D₂) and a straight line connecting points (T₁', D₁') and (T₂', D₂'). The slope between T₁ and T₂ is defined as a linear expansion coefficient (linear expansion coefficient 1) of a region where the temperature is not larger than Tg, whereas the slope between T₁' and T₂' is defined as a linear expansion coefficient (linear expansion coefficient 2) of a region where the temperature is not smaller than Tg.

### Warpage measurement

Using a 12-inch silicon wafer of a thickness of 775 µm, the heat-curable resin composition was subjected to compression molding in a wafer mold by APIC YAMADA CORPORATION at 175°C for 600 sec to obtain a molded product of a resin thickness of 500 µm, followed by completely curing (i.e. post-curing) the same under the condition of 180°C for 1 hour. Warpage (mm) was measured thereafter.

### Reliability test

Semiconductor chips were prepared as follows. That is, a screen printer for thick film (THICK FILM PRINTER TYPE MC 212) was used to print on an 8-inch silicon wafer of a thickness of 200 µm a die bonding material SFX-513M1 (by Shin-Etsu Chemical Co., Ltd.) at a thickness of 20 µm. A dicing apparatus was then used to cut the printed specimen into 7-mm dices while the specimen was still in B-stage.

Next, a flip chip bonder (NM-SB50A by Panasonic Corporation) was used to bond the produced semiconductor chips to the 8-inch and 200 µm-thick silicon wafer, under a condition of 10N/150°C/1.0 sec. In this way, there was obtained a silicon wafer with the semiconductor chips mounted thereon.

The semiconductor chip-mounted silicon wafer was then placed in a compression molding device, followed by placing thereon an appropriate amount of the heat-curable resin composition so as to then cure the heat-curable resin composition at 175°C for 10 min, where a maximum value of the molding pressure applied was 15 to 30 MPa. A silicon wafer was thus obtained. The amount of the heat-curable resin composition was adjusted to that allowing the resin thickness to become 500 µm ± 10 µm after molding. Such silicon wafer was then subjected to post-curing where the silicon wafer was heat-treated in an oven at 180°C for an hour. Later, a dicing apparatus was again used to cut the post-cured silicon wafer into 7.1 mm × 7.1 mm dices, thus obtaining a separated resin-mounted semiconductor chip having a thickness of 500 µm ± 10 µm.

The above semiconductor chips were then subjected to a hygroscopic treatment for 168 hours under a condition of 85°C and 85%RH. The semiconductor chips thus treated were further subjected to a solder heat resistance test (peeling inspection) where the semiconductor chips were inserted through a reflow oven three times, the reflow oven being previously configured in a manner such that a temperature range was within 255 to 260°C (i.e. maximum temperature 260°C) for 30 sec ± 3 sec. An ultrasonic flaw detector (QUANTUM 350 by SONIX) was used to inspect a peeling state inside the semiconductor chips in a nondestructive manner with a 75 MHz probe. Here, examples exhibiting no peelings or cracks were marked "Favorable," whereas examples exhibiting peelings or cracks were marked "NG."

**Table 1**

| Composition (part by mass) | | Working example | | | | | Comparative example | | | | | | |
|---|---|---|---|---|---|---|---|---|---|---|---|---|---|
| | | 1 | 2 | 3 | 4 | 5 | 1 | 2 | 3 | 4 | 5 | 6 | 7 |
| (A)Cyanate ester compound | (A1) (Viscosity:0.08Pa·s) | 95 | 95 | 95 | 95 | 90 | 95 | 95 | 95 | 95 | 95 | 95 | 95 |
| | (A2) (Viscosity:250Pa·s) | | | | | 5 | | | | | | | |
| (B)Phenol curing agent | (B1) Resorcinol type | 5 | | 5 | 5 | 5 | 5 | 5 | 5 | 5 | 5 | 5 | 5 |
| | (B2) Resorcinol type | | 5 | | | | | | | | | | |
| (C)Curing accelerator | (C1) DBU-type tetraphenylborate salt | 0.5 | 0.5 | 0.5 | 0.5 | 0.5 | 0.5 | 0.5 | 0.5 | 0.5 | 0.5 | 0.5 | 0.5 |
| (D)Inorganic filler | (D1) Treated silica (KBM573,12µm) | 1850 | 1850 | 1850 | 1850 | 1400 | 1850 | 1850 | 1150 | 2300 | | | |
| | (D2) Treated silica (KBM403,12µm) | | | | | | | | | | 1850 | | |
| | (D3) Treated silica (KBM573,0.8µm) | | | | | | | | | | | 1850 | |
| | (D4) Silica (12µm) | | | | | | | | | | | | 1850 |
| (E)Ester compound | (E1) Montanic acid ester compound | 3 | 3 | 5 | 1 | 3 | 0 | 11 | 3 | 3 | 3 | 3 | 3 |
| (F)Other additives | (F1) Adhesion imparting agent | 1 | 1 | 1 | 1 | 1 | 1 | 1 | 1 | 1 | 1 | 1 | 1 |
| | (F2) Carbon black | 1 | 1 | 1 | 1 | 1 | 1 | 1 | 1 | 1 | 1 | 1 | 1 |
| Evaluation item | Sheet-like shape | Favorable | Favorable | Favorable | Favorable | Favorable | Favorable | Favorable | Favorable | Failed to be molded into sheet-like shape (NA) | Failed to be molded into sheet-like shape (NA) | Failed to be molded into sheet-like shape (NA) | Failed to be molded into sheet-like shape (NA) |
| | Glass-transition temperature [Tg] (°C) | 220 | 225 | 225 | 220 | 240 | 250 | 220 | 220 | | | | |
| | Linear expansion coefficient 1 (ppm/°C) | 4.1 | 4.1 | 4.2 | 4.5 | 4.1 | 4.0 | 4.5 | 5.2 | | | | |
| | Filling failure (Yes · No) | No | No | No | No | No | No | No | No | | | | |
| | Warpage amount (mm) | <1 | <1 | <1 | 2 | <1 | 4 | <1 | 20 | | | | |
| Reliability test | Presence or absence of peeling, crack (IR reflow) | Favorable | Favorable | Favorable | Favorable | Favorable | Favorable | NG | NG | | | | |

## Claims

1. A heat-curable resin composition for semiconductor encapsulation, comprising:
(A) a cyanate ester compound having not less than two cyanato groups in one molecule, the cyanate ester compound containing a cyanate ester compound (A-1) represented by the following formula (1), the cyanate ester compound (A-1) being contained in the whole cyanate ester compound as the component (A) by an amount of not smaller than 90% by mass, and exhibiting a viscosity of not higher than 50 Pa·s at 23°C when measured by a B-type rotary viscometer in accordance with a method described in JIS K7117-1:1999 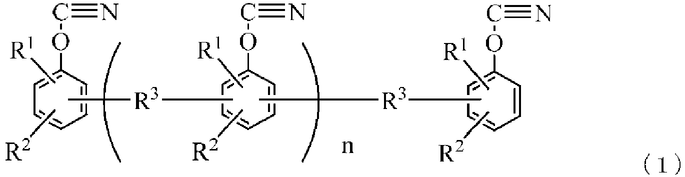 wherein n represents an integer of 0 or 1; each of R¹ and R² represents a hydrogen atom or an alkyl group having 1 to 4 carbon atoms; and R³ represents a divalent linking group selected from the groups expressed by the following formulae (2) to (5)
-CH2- (2) 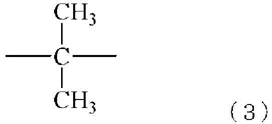 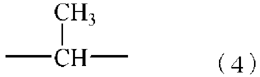
-O- (5) ;
(B) a phenol curing agent containing a resorcinol-type phenolic resin represented by the following formula (6), the component (B) being contained at a ratio at which the cyanato groups in the component (A) is in an amount of 0.5 to 100 equivalents per 1 equivalent of the hydroxyl groups (OH groups) in the component (B), 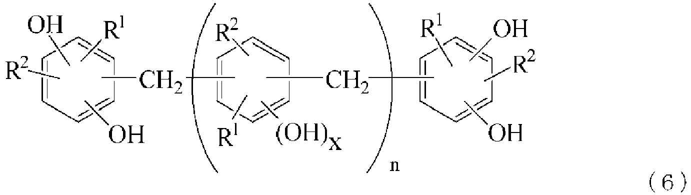 wherein n represents an integer of 0 to 10; each of R¹ and R² independently represents a hydrogen atom or a monovalent group selected from the group consisting of an alkyl group having 1 to 10 carbon atoms, an allyl group and a vinyl group; and x represents 1 or 2;
(C) a curing accelerator in an amount of 0.01 to 5 parts by mass per 100 parts by mass of the component (A);
(D) an inorganic filler comprising particles having either spherical or deformed sphere shapes, exhibiting on average an aspect ratio of 1 to 4, has an average particle diameter of 1 to 20 µm when measured by a laser diffraction method, the component (D) being in an amount of 1,200 to 2,200 parts by mass per 100 parts by mass of a sum total of the components (A) and (B), and has been surface-treated with a silane coupling agent represented by the following formula (7), the silane coupling agent being contained in an amount of 0.2 to 0.5 parts by mass per 100 parts by mass of the inorganic filler,
R¹ₐ(OR²)₍₃₋ₐ₎Si-C₃H₆-R³ (7)
wherein a represents an integer of 0 to 3; R¹ represents a methyl group or an ethyl group; R² represents an alkyl group having 1 to 3 carbon atoms; and R³ represents a group selected from the group consisting of the nitrogen-containing functional groups represented by the following formulae (8) to (11)
-NH₂ (8)
-NHC₆H₅ (9)
-NHC₂H₄NH₂ (10) 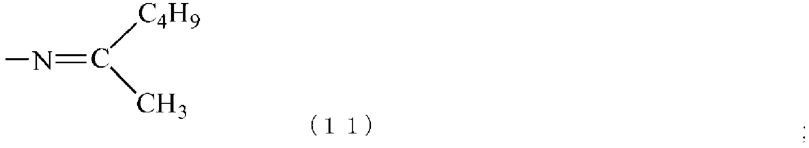
and
(E) an ester compound that is in an amount of 1 to 10 parts by mass per 100 parts by mass of the sum total of the components (A) and (B), and is represented by the following formula (12)
R⁴-CH₂CH₂-NH-CH₂CH₂-R⁵ (12)
wherein each of R⁴ and R⁵ represents a saturated ester residue having 2 to 30 carbon atoms.

2. The heat-curable resin composition for semiconductor encapsulation according to claim 1, exhibiting a linear expansion coefficient of 3.0 to 5.0 ppm/°C as a result of measuring a 5×5×15 mm specimen at a rate of temperature increase of 5°C / min and under a load of 19.6 mN, in accordance with a method described in JIS K 7197:2012.

3. A method for producing a resin-encapsulated semiconductor device, comprising:
a step of using a cured product of the heat-curable resin composition for semiconductor encapsulation as set forth in any one of claims 1 or 2 to collectively encapsulate an entire silicon wafer or substrate with at least one semiconductor element mounted thereon, wherein
the heat-curable resin composition for semiconductor encapsulation is applied either in a pressurized manner, or in a depressurized manner under a vacuum atmosphere, before being heated and cured to encapsulate the semiconductor element.

## Patentansprüche

1. Wärmehärtbare Harzzusammensetzung für die Halbleitereinkapselung, umfassend:
(A) eine Cyanatesterverbindung mit nicht weniger als zwei Cyanatgruppen in einem Molekül, wobei die Cyanatesterverbindung eine durch die folgende Formel (1) dargestellte Cyanatesterverbindung (A-1) enthält, wobei die Cyanatesterverbindung (A-1) in der gesamten Cyanatesterverbindung als Komponente (A) in einer Menge von nicht kleiner als 90 Massen-% enthalten ist und eine Viskosität von nicht mehr als 50 Pa · s bei 23 °C aufweist, wenn sie von einem Rotationsviskosimeter vom B-Typ gemäß einem in JIS K7117-1:1999 beschriebenen Verfahren gemessen wird, 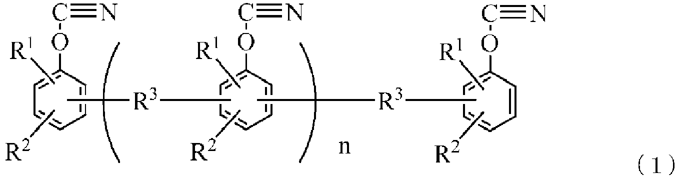 worin n für eine Ganzzahl von 0 oder 1 steht; jedes von R¹ und R² für ein Wasserstoffatom oder eine Alkylgruppe mit 1 bis 4 Kohlenstoffatomen steht; und R³ für eine zweiwertige Bindungsgruppe steht, die aus den durch die folgenden Formeln (2) bis (5) ausgedrückten Gruppen ausgewählt ist
-CH₂- (2) 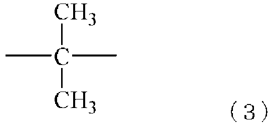 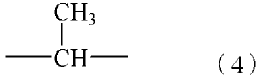
-O- (5) ;
(B) ein Phenolhärtungsmittel, enthaltend ein Phenolharz vom Resorcin-Typ, dargestellt durch die folgende Formel (6), wobei die Komponente (B) in einem Verhältnis enthalten ist, bei dem die Cyanatogruppen in der Komponente (A) in einer Menge von 0,5 bis 100 Äquivalenten pro 1 Äquivalent der Hydroxylgruppen (OH-Gruppen) in der Komponente (B) vorliegen, 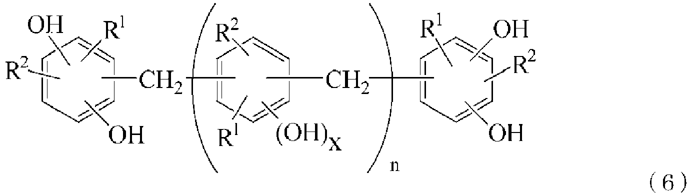 worin n für eine Ganzzahl von 0 bis 10 steht; jedes von R¹ und R² unabhängig voneinander für ein Wasserstoffatom oder eine einwertige Gruppe steht, die aus der aus einer Alkylgruppe mit 1 bis 10 Kohlenstoffatomen, einer Allylgruppe und einer Vinylgruppe bestehenden Gruppe ausgewählt ist; und x für 1 oder 2 steht;
C) einen Härtungsbeschleuniger in einer Menge von 0,01 bis 5 Massenteilen pro 100 Massenteile der Komponente (A);
(D) ein anorganischer Füllstoff, der Partikeln mit entweder Kugelformen oder verformten Kugelformen umfasst, die im Durchschnitt ein Aspektverhältnis von 1 bis 4 aufweisen, einen mittleren Partikeldurchmesser von 1 bis 20 µm, wenn mittels eines Laserbeugungsverfahrens gemessen, hat, wobei die Komponente (D) in einer Menge von 1.200 bis 2.200 Massenteilen pro 100 Massenteile einer Gesamtsumme der Komponente (A) und (B) vorliegt und mit einem durch die folgende Formel (7) dargestellten Silan-Kupplungsmittel oberflächenbehandelt wurde, wobei das Silan-Kupplungsmittel in einer Menge von 0,2 bis 0,5 Massenteilen pro 100 Massenteile des anorganischen Füllstoffs enthalten ist,
R¹ₐ(OR²)₍₃₋ₐ₎Si-C₃H₆-R³ (7)
worin a für eine Ganzzahl von 0 bis 3 steht; R¹ für eine Methylgruppe oder eine Ethylgruppe steht; R² für eine Alkylgruppe mit 1 bis 3 Kohlenstoffatomen steht; und R³ für eine Gruppe steht, die aus der Gruppe ausgewählt ist, welche aus den, durch die folgenden Formeln (8) bis (11) dargestellten, stickstoffhaltigen funktionellen Gruppen besteht
-NH₂ (8)
-NHC₆H₅ (9)
-NHC₂H₄NH₂ (10) 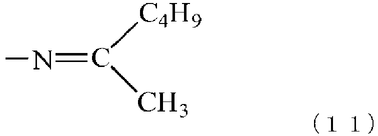
und
(E) eine Esterverbindung, die in einer Menge von 1 bis 10 Massenteilen pro 100 Massenteile der Gesamtsumme der Komponente (A) und (B) vorliegt und durch die folgende Formel (12) dargestellt wird
R⁴-CH₂CH₂-NH-CH₂CH₂-R⁵ (12)
worin jedes von R⁴ und R⁵ für einen gesättigten Esterrest mit 2 bis 30 Kohlenstoffatomen steht.

2. Wärmehärtbare Harzzusammensetzung für die Halbleitereinkapselung nach Anspruch 1, die einen linearen Ausdehnungskoeffizienten von 3,0 bis 5,0 ppm/°C als Ergebnis der Messung einer 5 × 5 × 15 mm-Probe bei einer Rate einer Temperaturerhöhung von 5 °C/min und unter einer Last von 19,6 mN gemäß einem in JIS K 7197:2012 beschriebenen Verfahren aufweist.

3. Verfahren zur Herstellung einer harzgekapselten Halbleitervorrichtung, umfassend:
einen Schritt des Verwendens eines gehärteten Produkts der wärmehärtbaren Harzzusammensetzung für die Halbleitereinkapselung nach einem der Ansprüche 1 oder 2, um kollektiv einen gesamten Siliziumwafer oder ein Substrat mit mindestens einem daran angebrachten Halbleiterelement einzukapseln, wobei
die wärmehärtbare Harzzusammensetzung für die Halbleitereinkapselung entweder auf eine unter Druck stehende Weise oder auf eine drucklose Weise unter einer Vakuum-Atmosphäre aufgebracht wird, bevor sie erwärmt und ausgehärtet wird, um das Halbleiterelement einzukapseln.

## Revendications

1. Composition de résine thermodurcissable pour l'encapsulation de semi-conducteurs, comprenant :
(A) un composé ester cyanate ayant au moins deux groupes cyanato dans une molécule, le composé ester cyanate contenant un composé ester cyanate (A-1) représenté par la formule suivante (1), le composé ester cyanate (A-1) étant contenu dans l'entier composé ester cyanate comme le composant (A) dans une quantité non inférieure à 90% en masse, et présentant une viscosité non supérieure à 50 Pa·s à 23°C lorsqu'elle est mesurée par un viscosimètre rotatif de type B conformément à une méthode décrite dans JIS K7117-1:1999 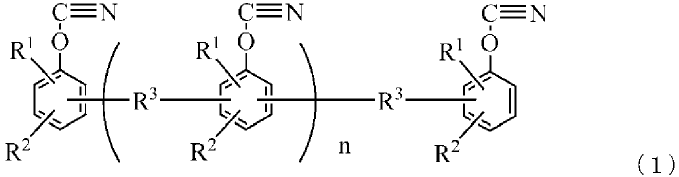 dans laquelle n représente un entier de 0 ou 1 ; chacun de R¹ et R² représente un atome d'hydrogène ou un groupe alkyle ayant 1 à 4 atomes de carbone; et R³ représente un groupe de liaison divalent sélectionné parmi les groupes exprimés par les formules suivantes (2) à (5)
-CH₂- (2) 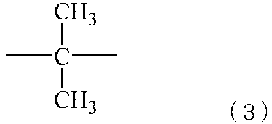 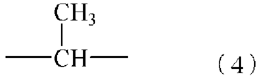
-O- (5) ;
(B) un agent de durcissement au phénol contenant une résine phénolique de type résorcinol représenté par la formule suivante (6), le composant (B) étant contenu dans un rapport par lequel les groupes cyanato dans le composant (A) est dans une quantité de 0,5 à 100 équivalents pour 1 équivalent des groupes hydroxyle (groupes OH) dans le composant (B), 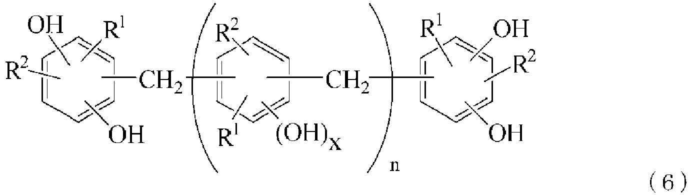 où n représente un nombre entier de 0 à 10 ; chacun de R¹ et de R² représente indépendamment un atome d'hydrogène ou un groupe monovalent choisi parmi un groupe constitué par un groupe alkyle ayant 1 à 10 atomes de carbone, un groupe allyle et un groupe vinyle ; et x représente 1 ou 2 ;
(C) un accélérateur de durcissement en une quantité de 0,01 à 5 parties en masse pour 100 parties en masse du composant (A) ;
(D) une charge inorganique comprenant des particules avec des formes soit sphérique soit sphérique déformées, présentant en moyenne un rapport d'aspect de 1 à 4, a un diamètre moyen de particules de 1 à 20 µm lorsqu'elle est mesurée par une méthode de diffraction laser, le composant (D) étant dans une quantité de 1.200 à 2.200 parties en masse pour 100 parties en masse d'une somme totale des composants (A) et (B), et a été traité en surface avec un agent de couplage au silane représenté par la formule suivante (7), l'agent de couplage au silane étant contenu dans une quantité de 0,2 à 0,5 parties en masse pour 100 parties en masse de la charge inorganique,
R¹ₐ(OR²)₍₃₋ₐ₎Si-C₃H₆-R³ (7)
où a représente un entier de 0 à 3 ; R¹ représente un groupe méthyle ou un groupe éthyle ; R² représente un groupe alkyle ayant 1 à 3 atomes de carbone ; et R³ représente un groupe choisi dans le groupe constitué des groupes fonctionnels contenant de l'azote représentés par les formules (8) à (11)
-NH₂ (8)
-NHC₆H₅ (9)
-NHC₂H₄NH₂ (10) 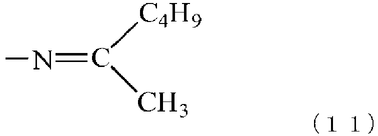
et
(E) un composé ester qui est dans une quantité de 1 à 10 parties en masse pour 100 parties en masse de la somme totale des composants (A) et (B), et est représenté par la formule suivante (12)
R⁴-CH₂CH₂-NH-CH₂CH₂-R⁵ (12)
dans laquelle chacun de R⁴ et R⁵ représente un résidu d'ester saturé ayant 2 à 30 atomes de carbone.

2. Composition de résine thermodurcissable pour l'encapsulation de semi-conducteurs selon la revendication 1, présentant un coefficient de dilatation linéaire de 3,0 à 5,0 ppm / °C à la suite de la mesure d'un échantillon de 5 × 5 × 15 mm à une vitesse d'augmentation de la température de 5°C / min et sous une charge de 19,6 mN, conformément à une méthode décrite dans JIS K 7197:2012.

3. Procédé de production d'un dispositif semi-conducteur encapsulé dans une résine, comprenant :
une étape d'utilisation d'un produit durci de la composition de résine durcissable à la chaleur pour l'encapsulation de semi-conducteurs selon l'une quelconque des revendications 1 ou 2, pour encapsuler collectivement une tranche de silicium entière ou substrat avec au moins un élément semi-conducteur monté sur celui-ci, dans lequel
la composition de résine thermodurcissable pour l'encapsulation de semi-conducteurs est appliquée soit sous pression, soit sans pression sous atmosphère de vide, avant d'être chauffée et durcie pour encapsuler l'élément semi-conducteur.
